Europäisches Patentamt

(19) European Patent Office

Office européen des brevets

(11) Veröffentlichungsnummer: **0 126 786**
**B1**

(12) **EUROPÄISCHE PATENTSCHRIFT**

(45) Veröffentlichungstag der Patentschrift:
01.04.87

(21) Anmeldenummer: 83105177.6

(22) Anmeldetag: 25.05.83

(51) Int. Cl.⁴: **G 03 F 1/00**

(54) Verfahren zum Übertragen eines Musters in eine strahlungsempfindliche Schicht.

(43) Veröffentlichungstag der Anmeldung:
05.12.84 Patentblatt 84/49

(45) Bekanntmachung des Hinweises auf die Patenterteilung:
01.04.87 Patentblatt 87/14

(84) Benannte Vertragsstaaten:
DE FR GB IT

(56) Entgegenhaltungen:
DE - B - 1 154 327

(73) Patentinhaber: IBM DEUTSCHLAND GMBH,
Pascalstrasse 100, D-7000 Stuttgart 80 (DE)

(84) Benannte Vertragsstaaten: DE

(73) Patentinhaber: International Business Machines
Corporation, Old Orchard Road, Armonk,
N.Y. 10504 (US)

(84) Benannte Vertragsstaaten: FR GB IT

(72) Erfinder: Bohlen, Harald, Dipl.-Phys., Schützenweg 77,
D-7030 Böblingen 4 (DE)
Erfinder: Bretscher, Erwin, Dipl.-Ing., Speerstrasse 18,
CH-8460 Rapperswil (CH)
Erfinder: Engelke, Helmut, Dr., Dipl.-Phys., Ahornweg 33,
D-7031 Altdorf (DE)
Erfinder: Greschner, Johann, Dr., Dipl.-Phys.,
Tiergartenweg 14, D-7401 Pliezhausen 2 (DE)
Erfinder: Nehmiz, Peter, Dr., Dipl.-Phys.,
Karl-Weller-Strasse 2, D-7000 Stuttgart 80 (DE)
Erfinder: Vettiger, Peter, Dipl.-Ing.,
Langmoosstrasse 33, CH-8135 Langnau a./A (CH)

(74) Vertreter: Oechssler, Dietrich, Dr. rer. nat., IBM
Deutschland GmbH Schönaicher Strasse 220,
D-7030 Böblingen (DE)

**Beschreibung**

Die Erfindung betrifft ein Verfahren zum Übertragen eines Musters in eine strahlungsempfindliche Schicht auf Substraten, bei dem zwei Teilmuster, welche, wenn sie in festgelegter Weise zueinander ausgerichtet aufeinandergelegt werden, das Muster ergeben, wobei Elemente der beiden Teilmuster sich zu Elementen des Musters ergänzen und wobei diese Teilmusterelemente bereichsweise einander überlappen, in der festgelegten Weise zueinander und zu den Substraten ausgerichtet mit einer geeigneten Strahlung auf die strahlungsempfindliche Schicht projiziert werden, wobei latent das Muster in der strahlungsempfindlichen Schicht entsteht, und bei dem dann die strahlungsempfindliche Schicht entwickelt wird. Unter Elementen werden dabei individuelle, in sich abgeschlossene Bereiche der Muster verstanden.

Zum Übertragen von Mustern in strahlungsempfindliche Schichten werden beispielsweise in der Halbleitertechnik, insbesondere, wenn dasselbe Muster oftmals übertragen werden soll, Masken eingesetzt. Werden Muster nicht oftmals, sondern höchstens einige Male übertragen, so kann es wirtschaftlich sein, nicht erst die Maske zu erzeugen, sondern direkt mit einem gesteuerten, fokussierten Elektronenstrahl das Muster auf das Substrat zu übertragen. Masken gehören im wesentlichen zwei Typen an. Bei dem einen Maskentyp ist das Maskenmuster in eine dünne Schicht eingeätzt, welche auf einer als Substrat dienenden Glasplatte aufgebracht ist und aus einer Gelatineemulsion oder aus einem Metall, wie z.B. Chrom, besteht. Bei dem anderen Maskentyp weist das beispielsweise aus einem Siliciumplättchen bestehende Substrat durchgehende Löcher auf, welche dem Maskenmuster entsprechen.

Bei der Herstellung beider Maskentypen wird das Muster – üblicherweise stark verkleinert – mittels selektiver Bestrahlung und anschliessender Entwicklung in eine auf dem Maskensubstrat aufgebrachte strahlungsempfindliche Schicht übertragen. Die Masken, bei welchen die Maske aus einer Gelatineemulsion besteht, sind dann bereits fertig (Emulsionsmasken), während bei den Masken, in welchen im fertigen Zustand das Maskenmuster in eine Metallschicht oder in das Maskensubstrat eingeätzt ist, das Muster in der strahlungsempfindlichen Schicht als Ätzmaske beim Ätzen der Metallschicht bzw. des Maskensubstrats verwendet wird. Die selektive Bestrahlung der strahlungsempfindlichen Schicht erfolgt entweder dadurch, dass die Schicht durch eine das Muster aufweisende Meistermaske hindurch bestrahlt wird oder indem die strahlungsempfindliche Schicht beispielsweise mit einem fokussierten Elektronenstrahl selektiv entsprechend dem gewünschten Maskenmuster beschrieben wird. Üblicherweise wird heutzutage auch die Meistermaske mittels selektiver Bestrahlung mit einem fokussierten Elektronenstrahl erzeugt. Die Befehle zur Steuerung des fokussierten Elektronenstrahls werden generiert, indem zunächst das Maskenmuster mittels eines graphischen, mit einem Rechner verbundenen Bildschirms programmgesteuert entworfen wird, und anschliessend im Speicher des Rechners gespeichert wird. Mittels eines Rechners werden dann in der genannten Weise vorliegende Maskenmuster in die Steuerbefehle für den Elektronenstrahl umgewandelt.

Die Masken dienen beispielsweise in der Halbleitertechnik dazu, um die Halbleiterplättchen für das Dotieren mit die Leitfähigkeit bestimmenden Verunreinigungen selektiv abzudecken, um in auf dem Halbleiterplättchen aufgebrachte Passivierungsschichten Öffnungen zum Kontaktieren von Bereichen des Halbleitermaterials zu ätzen und um Leiterzugnetze, beispielsweise zum Verbinden von Halbleiterbereichen untereinander, aus einer ganzflächig aufgebrachten Metallschicht zu erzeugen.

Mit dem zunehmenden Trend zur Mikrominiaturisierung und zur Höchstintegration bei integrierten Schaltungen werden die erforderlichen zu übertragenden Maskenmuster zunehmend komplizierter. Entsprechend schwieriger und aufwendiger wird die Herstellung der benötigten Masken. Die Erzeugung von Masken ist ein beachtlicher Kostenfaktor bei der Herstellung von integrierten Schaltungen. Verfahren, bei welchen sich der Aufwand für die Herstellung von Masken reduzieren lässt, sind deshalb von grossem Interesse. Ein solches Verfahren ist in dem Artikel «Method of Art Work Generation», welcher im IBM Technical Disclosure Bulletin, Band 21, Nr. 5, Oktober 1978, Seiten 1926 und 1927 veröffentlicht ist, beschrieben. Man muss dazu wissen, dass für die Herstellung elektronischer Rechenanlagen eine grosse Anzahl von Chips mit integrierten Schaltungen benötigt werden, welche sich voneinander unterscheiden und zum Teil nur in kleinen Stückzahlen benötigt werden. Es wäre ausserordentlich teuer, jeden Schaltkreistyp für sich zu prozessieren und auch für jeden Schaltkreistyp einen individuellen Satz von Masken zu entwerfen. Man geht deshalb so vor, dass alle Schaltkreise gemeinsam bis zu einem sehr fortgeschrittenen Stadium der Herstellung, nämlich bis zur Erzeugung der Leiterzugnetze gemeinsam prozessiert und erst dann unter Verwendung spezieller Verdrahtungsmasken die einzelnen gewünschten integrierten Schaltungen erzeugt werden. Aber auch die Herstellung, insbesondere der Entwurf, der speziellen Verdrahtungsmasken ist noch ziemlich aufwendig. Da sich die einzelnen benötigten Verdrahtungsmasken oft nur sehr wenig voneinander unterscheiden, wird deshalb in dem oben erwähnten Artikel vorgeschlagen, bei der Übertragung des Leiterzugmusters jeweils zwei Masken zu verwenden, von denen die eine die Musterelemente enthält, welche in allen Verdrahtungsmustern vorkommen und die deshalb für jeden Schaltungstyp verwendet werden kann, und die zweite Maske nur diejenigen Musterelemente enthält, durch welche sich die verschiedenen Leiterzugnetze unterscheiden, wobei die zweite Maske wegen der geringen Unterschiede, durch welche sich die verschiedenen Leiterzugmuster unterscheiden, im allgemeinen sehr einfach ist. Durch eine entsprechende Justierung der beiden Masken zueinander wird bei einer Bestrahlung des Substrats zuerst durch die eine Maske und dann durch die andere erreicht, dass das gesamte Leiterzugmuster, und zwar jeweils in seiner speziellen Ausbildung, auf das Substrat übertragen wird. Durch dieses Verfahren wird der Aufwand für die Masken zur Übertragung unterschiedlicher Leiterzugmuster beachtlich reduziert. Es ist allerdings schwierig, Fehler beim Übereinanderjustieren der beiden Masken zu vermeiden, und so ist es fast unausbleiblich, dass in dem auf das Substrat übertragenen Gesamtmuster an den Stellen, an welchen gemäss dem Schaltkreisentwurf Musterelemente in den beiden Masken bündig aneinanderstossen sollen, diese Musterelemente überlappen und/oder voneinander getrennt sind. Sind die Musterelemente getrennt voneinander, so ist dies in keinem Fall tolerierbar, weil die Folge im fertigen Schaltkreis eine unerwünschte Unterbrechung in einem Leiterzug ist. Eine zu starke Überlappung ist auch nicht akzeptabel, weil die mit der Überlappung verbundene doppelte Belichtung – jedenfalls, wenn diese Bestrahung mit Elektronen erfolgt – eine Verbreiterung («Ausblühung») eines Leiterzugs im fertigen Schaltkreismuster zur Folge hat, was bei der hohen Packungsdichte hochintegrierter Schaltungen einen Kurzschluss verursachen kann. Es wurde jedoch festgestellt, dass eine geringe Überlappung eine solche Verbreiterung der Leiterzüge nicht bewirkt, und die Autoren des obengenannten Artikels schlagen deshalb vor, zum Ausgleich kleiner Justierfehler die Masken so auszulegen, dass die Projektionen der sich ergänzenden Musterelemente bei optimaler Ausrichtung der beiden Masken zueinander nicht bündig aneinanderstossen, sondern etwas überlappen. Diese eingeplante Überlappung ist so konzipiert, dass bei Justierfehlern innerhalb der Fertigungstoleranz einerseits eine zu grosse, d.h. eine einen Kurzschluss verursachende Überlappung, und andererseits eine eine Leiterzugunterbrechung verursachende Trennung entsprechender Musterelemente vermieden wird.

Wird das Verdrahtungsmuster direkt mit einem fokussierten, rechnergesteuerten Elektronenstrahl übertragen, so ist, wenn die vorkommenden Verdrahtungsmuster sich nur wenig unterscheiden, auch dann die Aufteilung in zwei Teilmuster wirtschaftlich; denn das Erzeugen des Musters, welches der aufwendigste Teil beim Herstellen der Maske ist, muss ja auch bei der Erzeugung der Steuerbefehle für den Elektronenstrahl durchgeführt werden. Allerdings treten beim Übertragen von zwei Teilmustern mittels Elektronenstrahlen auch Justierfehler und die damit verbundenen Probleme auf.

Masken, welche aus einem Substrat mit durchgehenden, dem Maskenmuster entsprechenden Löchern bestehen, können keine Löcher enthalten, welche eine ringförmige Gestalt haben, da das innerhalb des Rings befindliche Substratmaterial keine Verbindung zum restlichen Substrat haben würde. Eine solche Maske sollte auch keine Lochelemente aufweisen, welche streifenförmige Zungen aus Substratmaterial begrenzen, da solche Zungen mechanisch instabil sind. Um trotzdem mit Lochmasken ringförmige und Zungen einschliessende Musterelemente auf ein Substrat übertragen zu können, wurde ein Verfahren entwickelt, welches in der DE-B-2739502 beschrieben ist. Dieses Verfahren sieht vor, das zu übertragende Muster in zwei Teilmuster zu zerlegen, welche keine ringförmigen und keine zungenförmigen Bereiche einschliessenden Musterelemente enthalten, welche jedoch übereinandergelegt sich zu solchen Musterelementen ergänzen können. Wird eine strahlungsempfindliche Schicht nacheinander durch zwei Masken bestrahlt, von denen jede eines der Teilmuster als Maskenmuster enthält, so lässt sich – unter der Voraussetzung, dass die beiden Masken exakt zueinander ausgerichtet sind, das Muster in die strahlungsempfindliche Schicht übertragen. Es wäre naheliegend, die Aufteilung in zwei Teilmuster so vorzunehmen, dass das eine Teilmuster – ausser an den Stellen, an welchen sich ringförmige und Zungen einschliessende Lochelemente befinden, mit dem Muster übereinstimmt und das andere Teilmuster lediglich die erforderlichen Musterergänzungen an den genannten Stellen beinhaltet. Die Aufteilung in die beiden Teilmuster wäre in diesem Fall relativ einfach. Unglücklicherweise treten aber bei einer solchen Aufteilung aus den folgenden Gründen Schwierigkeiten auf: Bei der Bestrahlung mit Elektronen erwärmt sich die Maske, und es ist dabei unvermeidlich, dass dabei eine gewisse Verzerrung des Maskenmusters eintritt. Diese Verzerrung ist nicht kritisch, da sie beim Entwurf des Musters berücksichtigt werden kann. Werden zwei Masken zur Übertragung des Musters verwendet, so müssen beide Masken in derselben Weise verzerrt sein. Dazu ist allerdings erforderlich, dass in den beiden Masken das Verhältnis von Lochflächen zu Substratflächen ungefähr gleich ist und dass auch die Verteilung der Löcher über das Substrat und die Grösse der Löcher in beiden Masken ungefähr dieselben sind. Nur wenn diese Bedingungen erfüllt sind, ist die durch die Strahlung aufgenommene Wärmemenge und die abgeleitete Wärmemenge und damit auch die auftretende Verzerrung bei beiden Masken dieselbe. Werden jedoch die genannten Bedingungen bei der Aufteilung in die beiden Teilmuster berücksichtigt, so ist diese Aufteilung, wenn sie mit zeichnerischen Mitteln durchgeführt wird, recht aufwendig. Wird jedoch das Maskenmuster in der oben angegebenen Weise in Steuerbefehle für einen fokussierten Elektronenstrahl umgewandelt, so kann an der Stelle, an welcher das Muster als Computerprogramm gespeichert vorliegt, die Aufteilung unter Berücksichtigung der obengenannten Bedingungen auch programmgesteuert vorgenommen werden.

Die weiter oben im Beispiel der Emulsions- oder Chrommasken beschriebenen Probleme, welche auftreten können, wenn beim Bestrahlen die zweite Maske nicht optimal zu der ersten ausgerichtet ist, treten auch auf, wenn zum Bestrahlen zwei Lochmasken verwendet werden. Das oben beschriebene Verfahren, bei der Herstellung der Teilmuster an den Stellen, an welchen einander entsprechende Musterelemente aneinanderstossen, Überlappungsbereiche vorzusehen, sollte deshalb auch bei der Musterübertragung mittels Lochmasken angewandt werden. Weisen die beiden Teilmuster – wie bei dem oben anhand der Emulsions- bzw. Chrommasken beschriebenen Beispiels nur wenige Musterelemente auf, welche sich zu Musterelementen des Musters ergänzen, so ist es relativ wenig aufwendig, die Überlappungsbereiche in den Maskenentwurf einzufügen. Ist jedoch die Anzahl der Stellen, an welchen Elemente der Teilmuster sich zu Elementen des Musters ergänzen, gross – dies ist z.B. dann der Fall, wenn die Aufteilung entsprechend den obengenannten Bedingungen stattfinden muss – so ist die nachträgliche Einfügung von Überlappungsbereichen – unabhängig davon, ob diese Einfügung mit zeichnerischen Mitteln oder programmgesteuert erfolgt – sehr aufwendig und/oder beinhaltet die grosse Gefahr, dass dabei Fehler auftreten.

Es ist die Aufgabe der Erfindung, ein Verfahren zur Übertragung eines Musters in strahlungsempfindliche Schichten anzugeben, bei dem zwei Teilmuster, welche entsprechend zueinander ausgerichtet aufeinandergelegt das Muster wiedergeben und welche dabei bereichsweise überlappen, auf die Schichten projiziert werden, wobei das Verfahren einfach durchzuführen und die Gefahr von Fehlern beim Entwurf der Teilmuster sehr gering ist.

Diese Aufgabe wird mit einem Verfahren der eingangs genannten Art mit den Merkmalen des kennzeichnenden Teils des Patentanspruchs 1 gelöst.

Die definierte Überlappung wird mit dem erfindungsgemässen Verfahren erreicht, weil das Schrumpfen und Aufweiten die Umrisslinien der einzelnen Elemente des Musters bzw. der Teilmuster nach innen bzw. nach aussen verschiebt und der Teil des Umrisses, welcher erst beim Zerschneiden eines Musterelementes entsteht, nur am Aufweiten, nicht aber am Schrumpfen teilnimmt.

Das erfindungsgemässe Verfahren stellt sicher, dass – sofern die Dimensionsänderungen beim Schrumpfen und Aufweiten richtig gewählt werden – auch dann, wenn beim Projizieren der beiden Teilmuster auf die strahlungsempfindlichen Schichten die vorkommenden Positionierfehler maximal sind, d.h., gerade noch innerhalb der zulässigen Toleranz liegen, keine unerwünschten Lücken zwischen sich ergänzenden Elementen der Teilmuster und keine so grossen Überlappungen von Elementen der Teilmuster auftreten, dass sich Verbreiterungen an den Überlappungsstellen (Ausblühungen) bilden.

In vorteilhafter Weise lässt sich das erfindungsgemässe Verfahren immer dann anwenden, wenn ein Muster, welches auf ein Substrat übertragen werden soll, zwischenzeitlich in zwei Teilmuster zerlegt werden muss bzw. soll und dann durch Übereinanderprojizieren der beiden Teilmuster wieder vereinigt wird. Das erfindungsgemässe Verfahren ist also verwendbar, um, wie in dem obengenannten Artikel im IBM Technical Disclosure Bulletin, den Aufwand bei der Erzeugung von Emulsions- bzw. Chrommasken oder auch von Befehlen zum Steuern von fokussierten Strahlen für die Herstellung einer Vielzahl von sich nur wenig voneinander unterscheidenden Metalisierungsmustern zu reduzieren, und auch, wenn Muster mittels Lochmasken übertragen werden sollen und das Muster, wenn es nicht aufgeteilt wird, Musterelemente aufweist, zu deren Übertragung ringförmige Lochelemente im Maskensubstrat bzw. Lochelemente, welche langgestreckte, zungenförmige Maskensubstratbereiche einrahmen, erforderlich wären.

Das Schrumpfen, Zerteilen und Aufweiten der Musterelemente kann entweder mit zeichnerischen Mitteln oder in besonders vorteilhafter Weise programmgesteuert durchgeführt werden.

Programmgesteuert lässt sich die Übertragung eines Musters in vorteilhafter Weise so durchführen, dass der Reihe nach das Muster am graphischen Bildschirm programmgesteuert und rechnerunterstützt entworfen, in maschinenlesbarer Form im Speicher eines Rechners abgespeichert wird, das abgespeicherte Muster programmgesteuert geschrumpft, in Teilmuster zerlegt und die Teilmuster dann auf die gewünschte Grösse aufgeweitet werden, die dann vorliegenden abgespeicherten Teilmuster in einem Postprozessor in Befehle zur Steuerung eines Elektronenstrahls umgewandelt werden, wobei die beiden Teilmuster je in strahlungsempfindliche Emulsionsschichten oder in eine auf Metallschichten oder auf Halbleitersubstraten aufliegende, strahlungsempfindliche Schicht latent übertragen werden, die übertragenden Teilmuster entwickelt werden, die Metallschichten bzw. Halbleitersubstrate unter Verwendung der entwickelten, strahlungsempfindlichen Schicht als Ätzmaske durchgeätzt werden und die dann vorliegenden Maskenmuster nacheinander und in genau festgelegter Weise zueinander ausgerichtet auf die ein Substrat bedeckende strahlungsempfindliche Schicht, in welche das Muster übertragen werden soll, projiziert werden.

Werden bei dem erfindungsgemässen Verfahren Lochmasken, d.h. Masken, welche aus einem Halbleitersubstrat bestehen, in welchem das Maskenmuster in Form durchgehender Löcher enthalten ist, erzeugt, so ist man mit dem Problem konfrontiert, dass die Fertigungstoleranzen nicht beliebig klein gemacht werden können, und dass deshalb die Lochabmessungen entweder grösser oder kleiner als der Sollwert sind. Da es üblich ist, dass die beiden je eines der Teilmuster wiedergebenden Masken auf einem Halbleitersubstrat unmittelbar benachbart untergebracht sind, weisen beide Masken die erwähnten Abweichungen vom Sollwert in genau gleicher Weise auf. In vorteilhafter Weise lässt sich diesem Problem begegnen, wenn beim Maskenentwurf die später als Löcher in die Maske eingebrachten Musterelemente so gross ausgelegt werden, dass sie um die bei der Herstellung der Löcher maximal auftretende Fertigungstoleranz grösser als gewünscht sind, wenn nach dem Herstellen der Löcher die tatsächliche Abweichung ihrer Abweichungen vom Sollwert ermittelt und wenn schliesslich durch Aufbringen von Material auf den Lochwänden die gewünschte Lochgrösse erzeugt wird. Das beschriebene Verfahren arbeitet also so, dass die durch Ätzen erzeugten Löcher mindestens so gross sind wie es ihrem Sollwert entspricht. Wird beim Abmessen festgestellt, dass der Sollwert vorliegt, so sind keine weiteren Massnahmen mehr erforderlich, die Maske ist fertig. Stellt man jedoch fest, dass die Löcher noch zu gross sind, so kann man mittels Kathodenzerstäubung oder mittels Aufdampfens auf das Substrat die Löcher definiert verkleinern und damit den Sollwert einstellen. Diese Variante des erfindungsgemässen Verfahrens beruht auf der Erkenntnis, dass auf ein Substrat durch Aufdampfen, wobei das Substrat erstens um eine Achse senkrecht zu seiner Oberfläche rotiert und zweitens in der Bedampfungskammer so aufgehängt ist, dass der Dampfstrahl schräg auf seine Oberfläche auftritt, oder durch Kathodenzerstäubung Material nicht nur auf den Oberflächen des Substrats, sondern auch – und zwar mit definierter Geschwindigkeit – auf den Lochwänden aufwächst. Es leuchtet ein, dass diese Variante des erfindungsgemässen Verfahrens nur anwendbar ist, wenn die Abmessungen der Löcher nach dem Ätzen entweder gleich dem Sollwert oder grösser als dieser sind. Als Material zum Verkleinern der Löcher wird bevorzugt ein gut wärmeleitfähiges Material, wie z.B. Gold, verwendet, weil dadurch zusätzlich erreicht wird, dass die durch auftreffende Strahlung zugeführte Wärmemenge rasch abgeführt wird und dadurch eine starke Erwärmung der Maske, und damit auch eine zu starke Deformation der Maske beim Bestrahlen verhindert wird.

Andere vorteilhafte Ausgestaltungen des erfindungsgemässen Verfahrens ergeben sich aus den Unteransprüchen. Das erfindungsgemässe Verfahren wird im folgenden anhand von durch Zeichnungen erläuterten Ausführungsbeispielen beschrieben. Es zeigen:

Fig. 1 einen Ausschnitt aus einem Maskenmuster, welches ein ringförmiges und ein solches Maskenelement beinhaltet, welches einen langgestreckten, zungenförmigen Bereich des Maskenmaterials einrahmt;

Fig. 2 und 3 zwei Teilmuster, deren Projektion auf ein Substrat, wenn sie in der richtigen Weise zueinander ausgerichtet sind, das in der Fig. 1 gezeigte Maskenmuster ergibt;

Fig. 4 die Projektion zweier Teilmuster auf ein Substrat, welche sich zu einem ringförmigen Musterelement ergänzen und welche optimal zueinander ausgerichtet sind;

Fig. 5 eine Projektion der in der Fig. 4 gezeigten Teilmuster, wobei jedoch die beiden Teilmuster nicht optimal zueinander ausgerichtet sind, so dass Überlappungen der Teilmuster und Unterbrechungen zwischen ihnen auftreten;

Fig. 6A bis 6C die Erzeugung von zwei Teilmustern aus einem Muster gemäss dem erfindungsgemässen Verfahren;

Fig. 6D die Projektion der in den Fig. 6B und 6C gezeigten (aufgeweiteten) Teilmuster auf ein Substrat bei optimaler Ausrichtung zueinander;

Fig. 7 einen Schnitt durch eine Lochmaske (in der in der Fig. 8 gezeigten Ebene B, parallel zur Maskenoberfläche), in der die Sollgrösse der Löcher durch nachträgliches Aufwachsen von Material an den Wänden der geätzten Löcher erzeugt worden ist, und

Fig. 8 einen Schnitt durch die in der Fig. 7 gezeigte Lochmaske (entlang der Ebene A in der Fig. 7, senkrecht zur Maskenoberfläche).

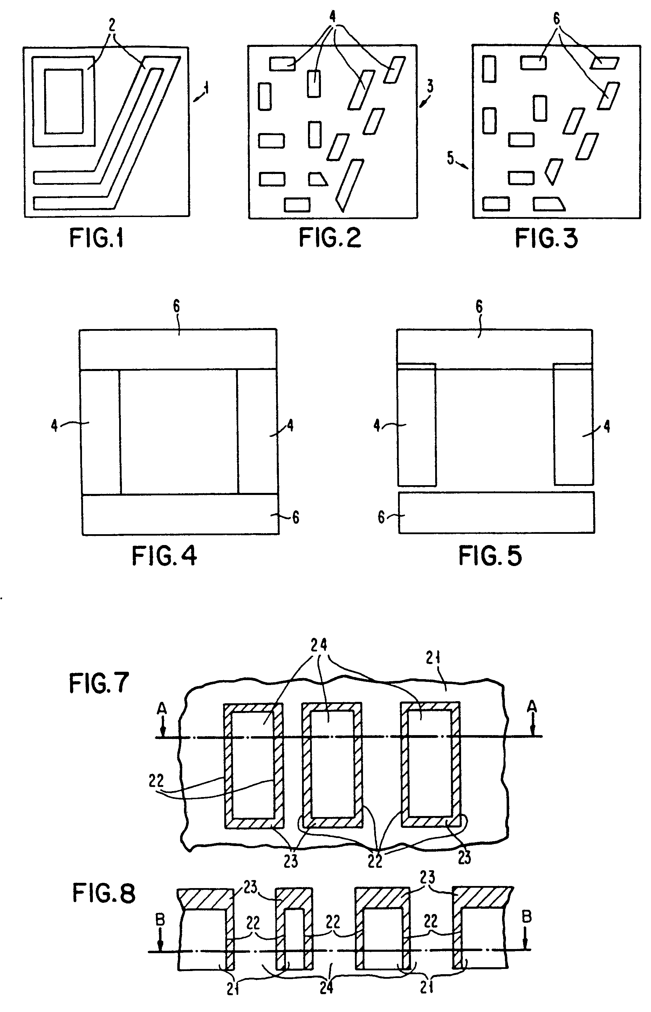

Die Fälle, in welchen eine Aufteilung eines auf ein Substrat zu übertragenden Musters zweckdienlich oder erforderlich ist, wurden bereits in der Beschreibungseinleitung angesprochen. Die Notwendigkeit der Aufteilung im zweiten Fall, bei dem die Übertragung des Musters mittels Lochmasken, d.h. mittels Masken, bei denen das Muster in Form von durchgehenden Löchern in einem Substrat vorliegt, und die zweckmässige Form der Aufteilung soll anhand der Fig. 1 bis 3 im folgenden erläutert werden.

Die Fig. 1 gibt einen Ausschnitt aus einem Muster 1 wieder, welches ein ringförmiges und ein solches Musterelement 2 aufweist, welches einen langgestreckten, zungenförmigen Bereich einschliesst. Es leuchtet unmittelbar ein, dass es möglich ist, dass ein solches ringförmiges Musterelement in Form eines durchgehenden Loches im Substrat vorhanden ist, weil das eingerahmte Substratmaterial keine Verbindung zum Rest des Substrats hat und deshalb herausfallen würde, und dass es zwar theoretisch möglich wäre, dass das andere in der Fig. 1 gezeigte Musterelement in einer Maske als durchgehendes Loch vorliegt, dass aber der von diesem Loch eingerahmte, langgestreckte, zungenförmige Substratbereich eine sehr geringe mechanische Stabilität hätte. Die genannten Schwierigkeiten lassen sich ausräumen, wenn das Maskenmuster in zwei komplementäre Teilmuster aufgeteilt wird. Eine gute Aufteilung muss Bedingungen erfüllen, welche im Hinblick auf die Herstellbarkeit und den späteren Einsatz der Maske in Bestrahlungsmaschinen aufgestellt worden sind. Dabei wurde insbesondere an Dünnfilmmasken in einem Siliciumsubstrat gedacht, welche Musterelemente im µm- und im Sub-µm-Bereich aufweisen und mit Elektronen-, Röntgen- oder Ionenstrahlen bestrahlt werden sollen. Das oberste Ziel ist eine optimale Treue der Übertragung des Musters auf das Substrat, wenn die beiden Teilmuster nacheinander auf das Substrat projiziert werden. Die Grundbedingungen, welche die Masken erfüllen müssen, sind also Herstellbarkeit, mechanische Stabilität und eine gute Wärmeleitfähigkeit in der Maskenebene. Es ist auch erforderlich, dass die beiden Masken bezüglich ihrer mechanischen und thermischen Eigenschaften gleichartig sind. Der folgende Satz von Regeln erlaubt die genannten Ziele in einer wirtschaftlichen und relativ einfachen Art und Weise zu verwirklichen:

1. Verteile die Teilmusterelemente in einer ungefähr gleichen Dichte über die beiden komplementären Masken.

2. Gehe beim Aufteilen des Musters so vor, dass einzelne Musterelemente aufgeteilt werden.

3. Teile so, dass im Muster vorhandene Innenecken wegfallen, damit mechanische Instabilitäten und das Herausfallen von Innenbereichen vermieden werden.

4. Teile grosse Elemente in Teile von einer festgelegten maximalen Länge.

5. Wenn ein Konflikt mit der Regel 7 entstehen würde, hat die Regel 3 Priorität vor der Regel 4.

6. Vermeide nichtherstellbare schmale Formen.

7. Vermeide Aufteilungen, bei denen eine schachbrettförmige Anordnung von Musterelementen entstehen würde.

Eine detailliertere Beschreibung der Aufteilung für die Herstellung von komplementären Lochmasken ist in dem IBM-Technical Report 28.120, herausgegeben von German Manufacturing Technology Center der IBM Deutschland GmbH in Sindelfingen, Deutschland, beschrieben. Die in den Fig. 2 und 3 gezeigten Teilmuster 4 und 6 sind unter Beachtung der oben angeführten Regeln durch Teilung des in der Fig. 1 gezeigten Musters 1 entstanden.

Die Fig. 4 zeigt die Projektion zweier Teilmusterelemente 4 und 6, welche optimal zueinander ausgerichtet sind, auf ein Substrat. Die beiden Teilmusterelemente 4 und 6 bilden zusammen ein ringförmiges Musterelement, wobei die Teilmusterelemente an den festgelegten Berührungslinien weder überlappen noch voneinander getrennt sind, sondern bündig aneinanderstossen. Die Fig. 5 zeigt die Projektion der in der Fig. 4 gezeigten Teilmusterelemente 4 und 6 auf ein Substrat, wobei jedoch die beiden Teilmusterelemente 4 und 6 nicht optimal zueinander ausgerichtet sind. Infolgedessen finden an den festgelegten Berührungslinien entweder Überlappungen der beiden Teilmusterelemente oder Unterbrechungen zwischen den beiden Teilmusterelementen statt. Es wurde festgestellt, dass eine Überlappung, d.h. eine Doppelbestrahlung der auf dem Substrat, auf welche das Muster übertragen werden soll, aufgebrachten strahlungsempfindlichen Schicht unkritisch ist, wenn die Überlappung festgelegte, von der Strahlungsenergie abhängige Werte nicht überschreitet, dass jedoch eine Unterbrechung zwischen den beiden Teilmustern, d.h. ein unbelichteter Streifen in einem Bereich der strahlungsempfindlichen Schicht auf dem Substrat, welcher vollständig belichtet werden soll, nicht toleriert werden kann. Wären die Teilmusterelemente 4 (siehe Fig. 4 und 5) um einen Betrag länger, der gleich ist der Breite der in der Fig. 5 gezeigten Unterbrechung, so würde keine Unterbrechung vorliegen. Allerdings könnte eine solche Verlängerung sich auch so auswirken, dass Überlappungsbereiche auftreten, die doppelt so breit sind wie die Unterbrechung in der Fig. 5, und wie oben ausgeführt wurde, kann ein zu breiter Überlappungsbereich auch nicht toleriert werden. Es wurde festgestellt, dass unter normalen Fertigungsbedingungen bei Anwendung der heute üblichen Bestrahlungsmaschinen die zur Kompensation der maximal auftretenden Ausrichtungsfehler der Überlappungsbereich nur eine Breite (ungefähr gleich dem doppelten Ausrichtungsfehler) haben muss, welche so klein ist (0,2 µ), dass bei der Bestrahlung mit Elektronenstrahlen mit einer Energie von 10 keVB noch kein «Ausblühen» auftritt. Das «Ausblühen» tritt auf, wenn mit Elektronenstrahlen doppelt belichtet wird. Die Ursache dafür ist die Streuung bzw. Rückstreuung, die die Elektronen beim Auftreffen auf die das Substrat bedeckende strahlungsempfindliche Schicht bzw. auf das Substrat selbst erleiden. Dadurch wird ein Teil der Strahlung in Nachbarbereiche «gesteuert», die nicht belichtet worden sind. Die Reichweite dieser Streuung ist abhängig von der primären Elektronenenergie und wird kleiner mit geringerer Energie. Bei einer Elektronenenergie von ungefähr 10 keV ist selbst für 0,5 µm breite Leiterzüge und einem entsprechend grossen Abstand zwischen den Leiterzügen bei einem 0,2 µm breiten Überlappungsbereich das «Ausblühen» noch vernachlässigbar gering.

Aufgrund des Streueffekts der Elektronen und der damit verbundenen Unschärfe der Abbildung kann bei der Verwendung von Elektronenstrahlen ein geringer Ausrichtungsfehler, welcher bei einer ganz scharfen Abbildung bereits eine Lücke zwischen sich ergänzenden Musterelementen hervorruft, noch toleriert werden. Grundsätzlich anders ist die Situation, wenn mit Röntgen- oder Ionenstrahlen belichtet wird. Aufgrund der vernachlässigbaren Streuung von Ionen findet eine wesentlich exaktere Abbildung des Maskenmusters statt als bei Verwendung von Elektronen (dafür ist bei Doppelbestrahlung die Gefahr von Ausblühungen praktisch nicht vorhanden, weshalb bei Masken für die Röntgen- und Ionenbestrahlung die Festlegung der Überlappungsbereiche unkritisch ist). Jede nicht ganz exakte Ausrichtung führt deshalb, wenn die Überlappungsbereiche nicht vorgesehen werden, zu nicht tolerierbaren Lücken zwischen einander ergänzenden Elementen der Teilmuster. Da Ausrichtungsfehler nicht auszuschliessen sind, sind Massnahmen, wie z.B. das erfindungsgemässe Verfahren, für die Herstellung von Masken, welche bei Röntgen- und Ionenstrahlverfahren eingesetzt werden sollen, absolut zwingend, während sie bei Masken für Elektronenstrahlverfahren in jedem Fall von Vorteil sind, da sie geringere Toleranzanforderungen bei der Ausrichtung der so hergestellten Masken und damit einen wirtschaftlicheren Einsatz derselben ermöglichen.

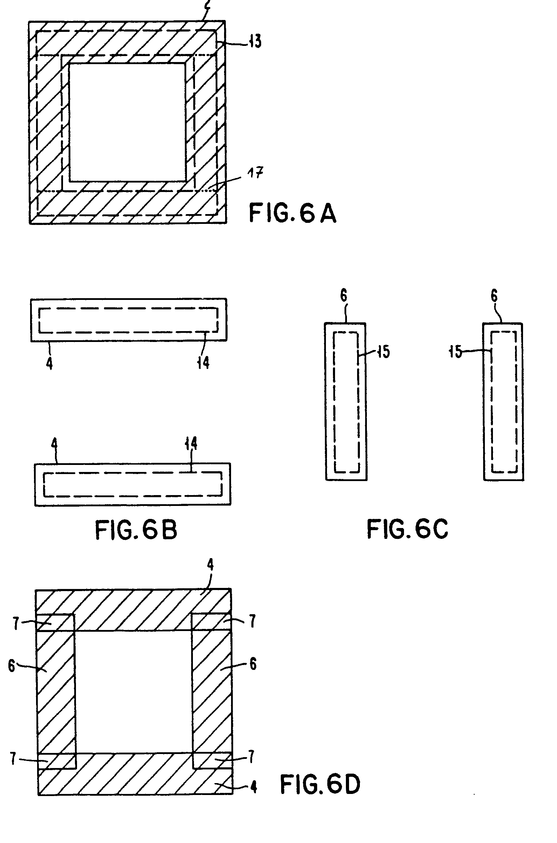

Anhand der Fig. 6A bis 6C soll im folgenden das erfindungsgemässe Verfahren besprochen werden.

Zunächst wird das gewünschte Muster entworfen. Entworfen wird entweder mit zeichnerischen Mitteln, beispielsweise an einem Reissbrett, oder programmgesteuert an einem graphischen Bildschirm unter Verwendung eines Repertoires graphischer Elemente. Die Fig. 6A zeigt beispielhaft ein ringförmiges Musterelement 2 (ausgezogene Linien), welches Teil des gewünschten Musters sein soll. Man muss sich vorstellen, dass das Musterelement 2 Teil eines Musters ist, welches eine Vielzahl von unterschiedlich geformten Musterelementen beinhaltet. Alle Operationen, die im folgenden anhand der in den Fig. 6A bis 6C gezeigten Musterelemente erläutert werden, werden entsprechend mit allen Musterelementen des Musters durchgeführt. Das entworfene Muster soll insbesondere bei der Herstellung von integrierten Schaltungen eingesetzt werden, d.h., dass das schliesslich in eine auf einem Substrat, beispielsweise einem Halbleitersubstrat, aufliegende strahlungsempfindliche Schicht übertragene Muster, gegenüber dem entworfenen Muster um einen sehr grossen Faktor verkleinert ist. Wird das Muster auf dem graphischen Bildschirm entworfen, so wird es anschliessend in maschinenlesbarer Form im Speicher eines Rechners abgespeichert.

Um das entworfene Muster in zwei Teilmuster zu zerlegen, welche beim Übereinanderprojizieren wieder das entworfene Muster wiedergeben und deren Projektion Überlappungsbereiche aufweist, muss das Muster nunmehr verschiedenen Operationen unterworfen werden. Im folgenden wird besprochen, wie diese Operationen rechnergesteuert ablaufen. Es sei jedoch klargestellt, dass die rechnergesteuerte Methode zwar besonders vorteilhaft ist, dass es aber auch ohne weiteres möglich ist, die genannten Operationen mit zeichnerischen Mitteln, beispielsweise am Reissbrett, vorzunehmen.

Zunächst wird das Musterelement 2 programmgesteuert geschrumpft, wobei die Schrumpfung senkrecht zu den Umrisslinien erfolgt. Erhalten wird bei dieser Operation das in der Fig. 6A gezeigte Musterelement 13 (gestrichelte Linie).

Das Schrumpfen und das weiter unten beschriebene Aufweiten von Mustern sind Beispiele für geometrische Manipulationen an Mustern. Solche Manipulationen werden häufig für die Überprüfung von Schaltkreisentwürfen auf die Einhaltung von vorgegebenen Entwurfsregeln benutzt. Beispielsweise kann dabei die Einhaltung von Mindestabständen zwischen den Musterelementen überprüft werden. Voraussetzung für die Durchführung der geometrischen Manipulationen mit Rechnern ist die Darstellung der Musterelemente in Form von Polygonen, welche durch eine Folge von Knotenkoordinaten beschrieben werden. Mittels des Rechners werden die Polygonkanten in geeigneter Weise verschoben. Durch Schnittpunktbildung werden dann neue Knotenkoordinaten berechnet, welche die geschrumpften bzw. aufgeweiteten Musterelemente definieren.

Im nächsten Verfahrensschritt wird das Musterelement 13 aufgeteilt. Das Aufteilen erfolgt wiederum programmgesteuert unter Einhaltung der oben angegebenen Regeln. Einzelheiten der rechnergesteuerten Aufteilung sind in dem oben erwähnten Technical Report 28.120 beschrieben. Bei der Aufteilung wird das Musterelement 13 in die in den Fig. 6B und 6C gezeigten Teilmusterelemente 14 und 15 (gestrichelte Linie) zerlegt, in dem entlang den Linien 17 (gepunktet) die Aufteilung vorgenommen wird. Bei der Aufteilung entlang den Linien 17 wird entsprechend der oben erwähnten Regel 3 verfahren, welche eine Aufteilung unter Vermeidung von Innenecken vorschreibt. Im nächsten Verfahrensschritt werden – wiederum mittels eines Programms, welches die entsprechenden Algorithmen enthält, die Teilmusterelemente 14 und 15 durch eine Verschiebung der Umrisslinien senkrecht zu den Umrisslinien aufgeweitet. Erhalten werden dabei die Teilmusterelemente 4 und 6 (ausgezogene Linie) in den Fig. 6B und 6C. Abgespeichert sind in diesem Verfahrensstadium im Speicher des Rechners die beiden Teilmuster, deren Projektion bei exakter Ausrichtung ein Muster ergibt, welches – abgesehen von einer möglichen Änderung des Massstabes – exakt mit dem ursprünglichen Muster übereinstimmt. Anschaulich zeigt dieses Ergebnis ein Vergleich zwischen den Fig. 6A und 6D. Die Fig. 6D zeigt die Projektion der Teilmusterelemente 4 und 6 bei exakter Ausrichtung zueinander. Da das Schrumpfen und das Aufweiten bei dem in den Fig. 6A bis 6C gezeigten Beispiel um denselben Betrag erfolgten, stimmt das in der Fig. 6A von den ausgezogenen Linien eingerahmte schraffierte Gebiet exakt mit dem in der Fig. 6D gezeigten schraffierten Gebiet überein. Es ist allerdings so, dass in der Projektion die Teilmusterelemente 6 nicht bündig an den Teilmusterelementen 4 anliegen, sondern dass die Projektion Überlappungsbereiche 7 aufweist.

Diese Überlappungsbereiche, welche den oben angesprochenen günstigen Effekt haben, werden dadurch verursacht, dass diejenigen Bereiche der Umrisslinien der Teilmusterelemente, welche erst beim Zerteilen entstehen, zwar am Aufweiten, aber nicht am Schrumpfen teilnehmen. Daraus ergeben sich dort Dimensionsänderungen, wo die Teilmusterelemente 6 und die Teilmusterelemente 4 aneinanderstossen, und die Folge davon sind die Überlappungsbereiche 7 in der Projektion der beiden Teilmuster aufeinander.

In diesem Stadium des Verfahrens liegen die beiden Teilmuster entweder – wenn die Operationen des Schrumpfens, Teilens und Aufweitens mittels zeichnerischer Mittel am Reissbrett durchgeführt worden sind – in Form eines auf Papier ausgeführten Plans oder wenn das Verfahren entsprechend der oben angegebenen Beschreibung durchgeführt worden ist, im Speicher des Rechners abgespeichert vor. Darauf, wie der auf Papier ausgeführte Plan dazu benutzt wird, um Masken herzustellen und mittels dieser Masken dann das entworfene Muster auf ein Substrat zu übertragen, soll im folgenden nicht mehr eingegangen werden. Dieses Verfahren ist seit langem in allen Einzelheiten bekannt. Es dürfte ausserdem fast vollständig durch ein anderes im folgenden ausführlicher behandeltes Verfahren abgelöst worden sein, von dem es sich im übrigen nicht grundsätzlich unterscheidet und mit dem es ausserdem viele Verfahrensschritte gemeinsam hat.

Die aufgeweiteten, im Speicher des Rechners abgespeicherten Teilmuster werden mittels eines Postprozessors in Befehle zur Steuerung eines bevorzugt aus Elektronen bestehenden fokussierten Strahls umgewandelt. Mittels dieses gesteuerten Strahls können die beiden Teilmuster direkt – d.h. ohne dass «echte» Masken verwendet werden, die «Masken» bestehen in diesem Fall aus den Steuerbefehlen – in eine das Substrat bedeckende strahlungsempfindliche Schicht übertragen werden. Das auf das Substrat übertragene Muster ist normalerweise gegenüber dem ursprünglich entworfenen stark verkleinert.

Soll das Muster sehr oft auf Substrate übertragen werden, so ist das direkte Einschreiben mit dem Elektronenstrahl im allgemeinen zu aufwendig, und der Elektronenstrahl wird dann nur dazu benutzt, um Masken, d.h. Emulsions-, Metall- oder Lochmasken zu erzeugen, mit denen dann die endgültige Übertragung des Musters auf die Substrate erfolgt.

Bei Emulsions- und Metallmasken befindet sich das Maskenmaterial auf einer unterstützenden Glasplatte. Zur Herstellung einer Emulsionsmaske geht man von einer auf dem Glassubstrat aufgebrachten strahlungsempfindlichen Schicht aus, welche selektiv mit dem gewünschten Muster bestrahlt und anschliessend entwickelt wird. Es liegt dann bereits die fertige Maske vor. Zur Herstellung einer Metallmaske, wobei als Metall bevorzugt Chrom verwendet wird, wählt man einen von zwei Wegen. Beim ersten Weg geht man von einer mit Metall beschichteten Glasplatte aus, bringt auf die Metallschicht einen strahlungsempfindlichen, beispielsweise positiven Lack auf, bestrahlt mittels des fokussierten Strahls den Lack entsprechend dem Negativ des gewünschten Musters, entwickelt den Lack und ätzt schliesslich das nicht vom Lack bedeckte Material weg. Dieses Verfahren wird als subtraktives Verfahren bezeichnet. Bei dem anderen Verfahren geht man von einer unbeschichteten Glasplatte aus, beschichtet diese mit einem beispielsweise positiven strahlungsempfindlichen Lack, bestrahlt den Lack mittels des fokussierten Strahls entsprechend dem gewünschten Muster, entwickelt den Lack, dampft dann auf die entwickelte Lackschicht und die freiliegenden Substratbereiche eine Metallschicht auf und entfernt dann mittels eines den Lack lösenden Lösungsmittels den restlichen Lack und das auf ihm liegende Metall. Dieses Verfahren wird als Abhebe- oder additives Verfahren bezeichnet. Emulsionsmasken und Metallmasken der besprochenen Art sind nicht geeignet zur Übertragung von Mustern mittels Elektronen-, Ionen- und Röntgenstrahlen. Deshalb wird ihre Bedeutung mit dem zunehmenden Trend zur Mikrominiaturisierung und zur Hochintegration sehr kleiner und dicht gepackter Bauelemente zunehmend geringer. Zur wirtschaftlichen Übertragung von Mustern mittels der genannten Strahlen sind Lochmasken günstig, bei denen das Substrat durchgehende Löcher in Form des zu übertragenden Musters aufweist.

Die Herstellung solcher Lochmasken, bei denen das Substrat aus einem Siliciumplättchen besteht, ist beispielsweise beschrieben in dem europäischen Patent 0001038. Zur Herstellung der Lochmaske wird das Siliciumplättchen einseitig mit Bor hochdotiert, so dass an der einen Oberfläche eine dünne Schicht aus $P^+$-Silicium entsteht. Anschliessend wird das Siliciumplättchen beidseitig durch thermische Oxidation mit einer Siliciumdioxidschicht überzogen. Anschliessend wird auf die an die hochdotierte Oberfläche angrenzende Oxidschicht eine bevorzugt aus einem positiven strahlungsempfindlichen Lack bestehende Schicht aufgebracht. In diese Schicht wird das gewünschte Muster mittels des fokussierten Strahls übertragen, und anschliessend wird die strahlungsempfindliche Lackschicht entwickelt. Unter Verwendung der noch verbliebenen Lackschicht als Ätzmaske wird dann das freiliegende Siliciumdioxid bis zum Siliciumsubstrat weggeätzt. Daraufhin wird unter Verwendung der Siliciumdioxidschicht als Ätzmaske, bevorzugt mittels reaktiven Ionenätzens, das freiliegende Silicium bis in eine Tiefe, welche dicker ist als die $P^+$-Siliciumschicht, weggeätzt. Schliesslich wird das Siliciumplättchen in den Bereichen, in welchen sich Bereiche des Musters befinden, durch Ätzen von der rückwärtigen, d.h. von der der hochdotierten abgewandten Oberfläche aus, dünn geätzt, wobei ein Ätzmittel, wie z.B. eine wässrige Mischung von Brenzkatechin und Äthylendiamin, verwendet wird, welches $P^+$-Silicium nicht ätzt, so dass der Ätzvorgang, wenn diese Schicht beim Dünnätzen erreicht wird, von sebst aufhört. Da die dem Maskenmuster entsprechenden Löcher tiefer in das Silicium hineingeätzt worden sind, als die $P^+$-Siliciumschicht dick ist, liegt nach dem Dünnätzen des Siliciumplättchens eine Lochmaske mit dem gewünschten Muster entsprechenden durchgehenden Löchern vor.

Es wird für jedes der Teilmuster eine Maske erzeugt. Gehört – wie dies bei den Lochmasken der Fall ist – zu jedem Teilmuster nur ein komplementäres Teilmuster, so werden die beiden Masken mit den Teilmustern bevorzugt auf bzw. in einem Substrat aneinandergrenzend erzeugt.

Das Substrat, auf welches das Muster übertragen werden soll, wird mit einer strahlungsempfindlichen Schicht abgedeckt. Um die beiden Masken mit den Teilmustern zum Substrat und zueinander auszurichten, muss das Substrat Justierhilfen, wie z.B. Justierpunkte oder ein zuvor aufgebrachtes Muster, aufweisen. Zu dem so ausgestatteten Substrat wird zunächst die Maske mit dem einen Teilmuster in festgelegter Weise ausgerichtet, wobei die Maske vom Substrat einen Abstand in der Grössenordnung von 0,5 mm hat. Durch ganzflächige Bestrahlung der Maske wird dann das eine Teilmuster latent in die strahlungsempfindliche Schicht übertragen. Anschliessend wird die Maske mit dem anderen Teilmuster in festgelegter Weise zum Substrat und damit auch zu dem bereits latent in die strahlungsempfindliche Schicht übertragenen einen Teilmuster ausgerichtet und dann ganzflächig bestrahlt, um auch das andere Teilmuster latent in die strahlungsempfindliche Schicht zu übertragen. Es folgt die Entwicklung, bei welcher das Muster, d.h. die Summe aus den beiden Teilmustern, in der strahlungsempfindlichen Schicht erzeugt wird (Voraussetzung dafür ist, dass die strahlungsempfindliche Schicht aus einem Positivlack besteht). Unter der Voraussetzung, dass die zulässigen Toleranzen bei der Ausrichtung der Masken nicht überschritten wurden, weist das Muster in der strahlungsempfindlichen Schicht weder unerwünschte Unterbrechungen, was gemäss dem Stand der Technik insbesondere bei der Übertragung mit Ionenstrahlen auftritt, noch Ausblühungen, welche als Folge von Doppelbestrahlungen in zu grossen Bereichen bei der Verwendung von UV-Licht oder Elektronenstrahlen wegen der mit diesen Strahlarten verbundenen Streueffekte auftreten können, auf. Die Übertragung des in der strahlungsempfindlichen Schicht erzeugten Musters in das Substrat wird bewerkstelligt, indem unter Verwendung der strahlungsempfindlichen Schicht als Maske die nicht von der Maske bedeckten Substratbereiche bis in eine festgelegte Tiefe weggeätzt werden. Auf diese Weise können beispielsweise in eine auf einem Halbleiterplättchen aufgebrachte Oxidschicht Fenster zur Kontaktierung und zum selektiven Einbringen von dotierenden Verunreinigungen in das Halbleitermaterial, oder auch ein Leiterzugmuster aus einer auf einem Halbleiterplättchen aufgebrachten Metallschicht erzeugt werden. Im letzteren Fall – unter der Voraussetzung, dass die strahlungsempfindliche Schicht aus einem Positivlack besteht – gibt die geätzte Metallschicht das Negativ des ursprünglich entworfenen Musters wieder. Ein Leiterzugmuster, welches dem ursprünglich entworfenen Muster entspricht, kann auf einem Substrat erzeugt werden, wenn nach dem Entwickeln der strahlungsempfindlichen Schicht ganzflächig eine Metallschicht aufgedampft wird und anschliessend unter Verwendung eines die strahlungsempfindliche Schicht lösenden Lösungsmittel die strahlungsempfindliche Schicht und das auf ihr liegende Metall entfernt wird.

Aus den obigen Ausführungen ergibt sich, dass das erfindungsgemässe Verfahren besonders vorteilhaft zur Herstellung von komplementären Lochmasken eingesetzt werden kann. Das Aufteilen des Musters in zwei Teilmuster und die Erzeugung von Bereichen in den beiden Teilmustern, welche bei der Projektion der beiden Teilmuster auf ein Substrat überlappen, mittels Schrumpfens und Aufweitens des Musters bzw. der Teilmuster erfolgt bevorzugt programmgesteuert. Die mittels des erfindungsgemässen Verfahrens hergestellten, die beiden Teilmuster beinhaltenden Masken sind bezüglich ihrer mechanischen Stabilität und ihres thermischen Verhaltens vollkommen gleichartig, und bei ihrer Verwendung ist sichergestellt, dass das Muster mit hoher Mustertreue auf das Substrat übertragen wird und dass unerwünschte Unterbrechungen und Ausblühungen in dem übertragenen Muster vermieden werden.

Bei den obigen Ausführungen zu dem erfindungsgemässen Verfahren wurde eine Fehlerquelle beim Übertragen von Mustern nicht berücksichtigt, welche eine Rolle spielen kann, wenn es bei der Übertragung auf eine ganz extreme Mustertreue ankommt. Das Entwickeln einer strahlungsempfindlichen Schicht nach dem Bestrahlen, beispielsweise bei der Herstellung der Masken, wird mittels eines Nassprozesses durchgeführt. Bei diesem Prozess müssen Fertigungstoleranzen in Kauf genommen werden, durch welche die Genauigkeit der Musterübertragung beeinträchtigt wird. Werden bei dem erfindungsgemässen Verfahren Lochmasken erzeugt, so lässt sich diese Fehlerquelle eliminieren. Diese Ausgestaltung des erfindungsgemässen Verfahrens, welche anhand der Fig. 7 und 8 besprochen werden soll, beruht auf der Erkenntnis, dass, wenn auf die Oberfläche von Lochmasken entweder durch Kathodenzerstäubung oder durch schräges Aufdampfen auf die um eine Achse senkrecht zu ihrer Oberfläche rotierende Maske Material aufgebracht wird, definierte Mengen des Materials auch an den Lochwänden aufwachsen, wodurch die Dimension der Löcher sich verkleinert. Die Ausgestaltung des erfindungsgemässen Verfahrens wird wie folgt durchgeführt: Die Elemente der Teilmuster werden grösser dimensioniert, als dem Sollwert entspricht. Die Vergrösserung wird so festgelegt, dass die Löcher im Maskensubstrat, welche unter Zugrundelegung des Teilmusters mit den vergrösserten Elementen erzeugt worden sind, auch bei Ausnutzung der maximalen Fertigungstoleranzen entweder genau auf dem gewünschten Sollwert oder aber grösser als dieser sind. Die gezielte Vergrösserung der Elemente in dem Teilmuster wird erreicht, indem bereits beim Entwurf des Musters diese Vergrösserung vorgenommen wird, oder indem zwar von dem gewünschten Muster ausgegangen wird, aber durch entsprechende Festlegung der Beträge, um welche geschrumpft bzw. aufgeweitet wird, die gewünschte Vergrösserung der Elemente der Teilmuster erreicht wird. Nach dem Erzeugen der Löcher werden die Lochdimensionen gemessen. Diese Messung lässt sich beispielsweise mittels eines Elektronenstrahl-Rastermikroskops mit einer Genauigkeit, die besser als 0,1 μm ist, durchführen. Wird festgestellt, dass die Löcher die Sollgrösse haben, so ist keine weitere Operation notwendig; die Maske ist fertig. Sind die Löcher grösser als dem Sollwert entspricht, so muss Material aufgebracht werden, um sie zu verkleinern. Als Material zum Verkleinern der Löcher sind sicher viele Materialien geeignet, bevorzugt wird jedoch Gold verwendet. Wie bereits erwähnt, kann das Material, wie z.B. das Gold, entweder durch schräges Aufdampfen auf die Maskenoberfläche, welche dabei um eine Achse senkrecht zu ihrer Oberfläche rotiert oder durch Kathodenzerstäubung aufgebracht wird. Wird bei der Kathodenzerstäubung mit einer grossflächigen Auftreffplatte, beispielsweise aus Gold, gearbeitet, so besitzen die auf der Maske auftreffenden Goldpartikel eine grosse Winkelverteilung. Dadurch wird, wie die Fig. 7 und 8, welche einen Ausschnitt aus einer Lochmaske 21 im Querschnitt parallel (Fig. 7) bzw. senkrecht (Fig. 8) zur Maskenoberfläche zeigen, das Material 23, z.B. Gold, nicht nur auf der Maskenoberfläche, sondern auch an den Wänden 22 der Maskenlöcher abgeschieden. Üblicherweise wird – wie auch in der Fig. 8 zu sehen ist – mehr Material 23 auf der Maskenoberfläche als auf den Lochwänden 22 aufgewachsen. Das Verhältnis der Dicken des auf der Maskenoberfläche und auf den Lochwänden 22 aufgewachsenen Materials hängt von der Winkelverteilung der auftreffenden Partikel ab. Bei einem von den Erfindern durchgeführten Experiment wurde mittels Kathodenzerstäubung auf der Maskenoberfläche eine Goldschicht von 0,85 µm Dicke und auf den Lochwänden 22 eine Goldschicht von 0,31 µm Dicke aufgewachsen. Entsprechende Ergebnisse werden erzielt, wenn das Material 23 mittels schrägen Aufdampfens auf die rotierende Maske aufgebracht wird, wobei das Verhältnis der Dicken des auf der Maskenoberfläche abgeschiedenen Materials und des an den Lochwänden 22 aufwachsenden Materials vom Winkel zwischen dem Dampfstrahl und der Maskenoberfläche abhängt. Überraschend ist, dass das Material sowohl beim Aufbringen mittels Kathodenzerstäubung als auch mittels Abdampfens an den Lochwänden sehr reprozierbar aufgewachsen werden kann, so dass es ohne weiteres möglich ist, Löcher 24 in der Maske zu erzeugen, welche genau die festgelegte Sollgrösse haben. Die beschriebene Ausgestaltung des erfindungsgemässen Verfahrens ist besonders vorteilhaft anwendbar, wenn, wie dies ja bei den Lochmasken üblich ist, die Masken mit den beiden Teilmustern sich auf demselben Substrat befinden. Da nämlich das gesamte Substrat sowohl beim Nassentwickeln als auch beim Aufbringen von Material genau denselben Verhältnissen ausgesetzt ist, weisen beide Masken nach dem Erzeugen der Löcher denselben Fehler auf, und wenn dann beide Masken demselben Kathodenzerstäubungs- oder Aufdampfprozess unterworfen werden, wird in beiden Masken die gewünschte Sollgrösse der Löcher zum selben Zeitpunkt erreicht. Dadurch gestaltet sich die beschriebene Ausgestaltung des erfindungsgemässen Verfahrens besonders einfach. Das Aufbringen von Gold hat noch den zusätzlichen Vorteil, dass eine Goldauflage die Wärmeleitfähigkeit der Masken erhöht, wodurch erreicht wird, dass sich die Maske beim Bestrahlen nicht stark erwärmt und dadurch die durch die Erwärmung der Maske verursachte Verzerrung des Maskenmusters vermindert wird. Die mittels der beschriebenen Ausgestaltung verbesserten Lochmasken werden dann, wie oben anhand der nicht korrigierten Lochmasken beschrieben, zum Übertragen des Musters auf das Substrat eingesetzt.

## Patentansprüche

1. Verfahren zum Übertragen eines Musters in eine strahlungsempfindliche Schicht auf Substraten, bei dem zwei Teilmuster, welche, wenn sie in festgelegter Weise zueinander ausgerichtet aufeinandergelegt werden, das Muster ergeben, wobei Elemente der beiden Teilmuster sich zu Elementen des Musters ergänzen und wobei diese Teilmusterelemente bereichsweise einander überlappen, in der festgelegten Weise zueinander und zu den Substraten ausgerichtet mit einer geeigneten Strahlung auf die strahlungsempfindliche Schicht projiziert werden, wobei latent das Muster in der strahlungsempfindlichen Schicht entsteht, und bei dem dann die strahlungsempfindliche Schicht entwickelt wird, dadurch gekennzeichnet, dass beim Entwurf der beiden Teilmuster von einem dem gewünschten Muster entsprechenden Muster ausgegangen wird, dass die Elemente (2) dieses Musters dann geschrumpft, anschiessend das geschrumpfte Muster in zwei den Teilmustern entsprechende geschrumpfte Teilmuster zerlegt und schliesslich die geschrumpften Teilmusterelemente (14, 15) auf die gewünschte Grösse der Teilmuster (4, 6) aufgeweitet werden.

2. Verfahren nach Anspruch 1, dadurch gekennzeichnet, dass beim Entwurf von einem mit dem zu übertragenden Muster identischen Muster ausgegangen wird und dass um dieselben Beträge geschrumpft und aufgeweitet wird.

3. Verfahren nach Anspruch 1 oder 2, dadurch gekennzeichnet, dass die Überlappungsbereiche (7) der Projektionen der sich ergänzenden Teilmusterelemente (4, 6) bei optimaler Ausrichtung 0,2 µm senkrecht zu der Linie, welche bei bündigem Aneinanderpassen sich ergänzender Teilmusterelemente (4, 6) die Grenze zwischen den beiden Teilmusterelementen (4, 6) bilden würde, nicht überschreiten.

4. Verfahren nach einem der Ansprüche 1 bis 3, dadurch gekennzeichnet, dass beim Übertragen zwei Masken, deren Maskenmuster mit je einem der Teilmuster identisch ist, verwendet werden.

5. Verfahren nach einem der Ansprüche 1 bis 4, dadurch gekennzeichnet, dass das Schrumpfen, Zerteilen und Aufweiten mit zeichnerischen Mitteln vorgenommen wird.

6. Verfahren nach einem der Ansprüche 1 bis 4, dadurch gekennzeichnet, dass das Schrumpfen, Zerteilen und Aufweiten programmgesteuert durchgeführt wird.

7. Verfahren nach Anspruch 6, dadurch gekennzeichnet, dass der Reihe nach das gewünschte Muster oder sein Negativ am mit einem Rechner verbundenen graphischen Bildschirm programmunterstützt entworfen und in maschinenlesbarer Form im Speicher des Rechners abgespeichert wird, das abgespeicherte Muster programmgesteuert geschrumpft, in geschrumpfte Teilmuster zerlegt und die geschrumpften Teilmuster dann auf die gewünschte Grösse aufgeweitet werden, die dann vorliegenden abgespeicherten Teilmuster in einem Postprozessor in Befehle zur Steuerung eines Elektronenstrahls umgewandelt werden, wobei die beiden Teilmuster je in eine auf dem Maskensubstrat bzw. auf einer das Maskensubstrat abdeckenden Metallschicht aufgebrachte strahlungsempfindliche Schicht latent übertragen werden, die strahlungsempfindlichen Schichten entwickelt werden, die Teilmuster in den strahlungsempfindlichen Schichten entweder mittels eines konventionellen Additiv- oder eines konventionellen Subtraktivprozesses in das Maskensubstrat oder in die auf dem Maskensubstrat aufliegende Metallschicht übertragen werden, die Teilmuster dann in zwei aufeinanderfolgenden Bestrahlungsschritten unter Verwendung der Masken genau zueinander ausgerichtet in eine ein Substrat bedeckende strahlungsempfindliche Schicht latent übertragen und die Schicht dann entwickelt wird.

8. Verfahren nach einem der Ansprüche 4 bis 7, dadurch gekennzeichnet, dass die beiden Masken in der Form einer Lochmaske, in welcher die beiden Teilmuster einander benachbart angeordnet sind und in welcher die Elemente der Teilmuster durchgehende Löcher sind, ausgebildet werden.

9. Verfahren nach Anspruch 7, dadurch gekennzeichnet, dass beim Musterentwurf die später als Löcher (24) in die Maske eingebrachten Teilmusterelemente so gross ausgelegt werden, dass sie um die bei der Herstellung der Löcher maximal auftretende Fertigungstoleranz grösser als gewünscht sind und dass nach dem Herstellen der Löcher die tatsächliche Abweichung ihrer Abmessungen vom Sollwert ermittelt und dass schliesslich durch Aufbringen von Material (23) auf den Lochwänden (22) die gewünschte Lochgrösse erzeugt wird.

10. Verfahren nach Anspruch 9, dadurch gekennzeichnet, dass das Material (23) durch schräges Aufdampfen auf die um eine Achse senkrecht zur Maskenoberfläche rotierende Maskenoberfläche oder durch Kathodenzerstäubung aufgebracht wird.

11. Verfahren nach Anspruch 9 oder 10, dadurch gekennzeichnet, dass als Material (23) ein gut leitendes Metall, wie z.B. Gold, aufgebracht wird.

## Claims

1. Method of transferring a pattern in a radiation-sensitive layer on substrates, where two partial patterns which, if superimposed upon each other in a predetermined alignment, yield the pattern, with elements of both partial patterns combining to form elements of the pattern and these partial pattern elements overlapping sectionally, aligned relative to each other and to the substrate in the predetermined manner, are projected with a suitable radiation to the radiation-sensitive layer, with the pattern being latently formed in the radiation-sensitive layer, and where the radiation-sensitive layer is then developed, characterized in that designing of the two partial pattern, that the elements (2) of this pattern are then exposed to a negative windage, that subsequently the negative windage pattern is partitioned into two negative windage partial patterns corresponding to the partial patterns, and that finally the negative windage partial pattern elements (14, 15) are exposed to a positive windage to the desired size of the partial patterns (4, 6).

2. Method as claimed in claim 1, characterized in that designing is based on a pattern identical with the pattern to be transferred, and the positive and negative windage is implemented to the same amounts.

3. Method as claimed in claim 1 or 2, characterized in that the overlap areas (7) of the projections of the combinatory partial pattern elements (4, 6), with optimum alignment, do not exceed 0.2 μm perpendicularly to the line which with flush fitting of complementary partial pattern elements (4, 6), would represent the demarcation between the two partial pattern elements (4, 6).

4. Method as claimed in any one of claims 1 to 3, characterized in that two masks whose pattern is identical with one respective of the partial patterns are used in the transfer.

5. Method as claimed in any one of claims 1 to 4, characterized in that the negative and positive windage and partitioning are implemented by drawing means.

6. Method as claimed in any one of claims 1 to 4, characterized in that the negative and positive windage and partitioning are implemented under program control.

7. Method as claimed in claim 6, characterized in that the desired pattern or its negative is serially designed under program control on a screen connected to a computer, and stored in machine readable form in the storage of the computer, that the stored pattern is exposed to a negative windage under program control, partitioned into negative windage partial patterns, and that the negative windage partial patterns are then exposed to a positive windage to the desired size, that the thus obtained stored partial patterns are then converted in a post processor into instructions for controlling an electron beam, with the two partial patterns being latently transferred respectively into a radiation-sensitive layer applied on the mask substrate, or on a metal layer covering the mask substrate, with the radiation-sensivite layers being developed, the partial patterns in the radiation-sensitive layers being transferred either by means of a conventional additive or a conventional substractive process into the mask substrate or the metal layer deposited on the mask substrate, with the partial patterns being subsequently precisely aligned relative to each other in two successive irradiaiton steps using the masks, and transferred into a radiation-sensitive layer covering a substrate, and with the layer being subsequently developed.

8. Method as claimed in any one of claims 4 to 7, characterized in that the two masks are designed in the form of a hole mask where both partial patterns are arranged adjacent to each other, and where the elements of the partial patterns are through-holes.

9. Method as claimed in claim 7, characterized in that when designing the pattern the partial pattern elements later to be inserted into the mask as holes (24) are dimensioned in such a manner that they are bigger than designed by the maximum manufacturing tolerance of the production of the holes, and that after the holes have been made the actual deviation of their dimensions from the nominal value is determined, and that finally by applying material (23) on the hole walls (22) the desired hole size is achieved.

10. Method as claimed in claim 9, characterized in that the material (23) is applied by obliquely directed evaporation on the mask surface rotating round an axis vertically to the mask surface, or by cathode sputtering.

11. Method as claimed in claims 9 or 10, characterized in that as material (23) a highly conductive metal as e.g. gold is applied.

**Revendications**

1. Procédé pour transférer un modèle dans une couche sensible au rayonnement sur des substrats, selon lequel deux modèles partiels qui reproduisent le modèle désiré lorsqu'ils sont placés l'un sur l'autre avec un alignement mutuel bien déterminé, auquel cas des éléments des deux modèles partiels se complètent pour former des éléments du modèle désiré et auquel cas ces éléments de modèles partiels de recouvrent mutuellement par zones, sont projetés, après avoir été alignés l'un part rapport à l'autre et par rapport au substrat de la manière déterminée, au moyen d'un rayonnement approprié sur la couche sensible au rayonnement, en formant ainsi de façon latente le modèle en question dans la couche sensible au rayonnement, et dans lequel la couche sensible au rayonnement est ensuite dévelopée, caractérisé en ce que, lors de la conception des deux modèles partiels, on part d'un modèle correspondant au modèle désiré, en ce que des éléments (2) de ce modèle sont ensuite réduits dimensionnellement, en ce qu'ensuite le modèle réduit est décomposé en deux modèles partiels réduits en correspondance aux modèles partiels et en ce qu'enfin les éléments de modèles partiels réduits (14, 15) sont agrandis à la grandeur désirée des modèles partiels (4, 6).

2. Procédé selon la revendication 1, caractérisé en ce que, lors de la conception, on part d'un modèle identique au modèle à transférer et on le réduit et on l'agrandit des mêmes valeurs.

3. Procédé selon une des revendications 1 ou 2, caractérisé en ce que les zones de recouvrement (7) des projections des éléments de modèles partiels se complétant (4, 6) ne dépassent pas, dans le cas d'un alignement optimal, 0,2 μm perpendiculairement à la ligne qui constituerait, dans le cas d'une adaptation bord à bord des éléments de modèles partiels se complétant (4, 6), la limite entre les deux éléments de modèles partiels (4, 6).

4. Procédé selon une des revendications 1 à 3, caractérisé en ce que, lors d'un transfert, on utilise deux masques dont le modèle de masque est identique à un des modèles partiels respectifs.

5. Procédé selon une des revendications 1 à 4, caractérisé en ce que la réduction, la division et l'agrandissement sont effectués avec des moyens du domaine du dessin.

6. Procédé selon une des revendications 1 à 4, caractérisé en ce que la réduction, la division et l'agrandissement sont réalisés par commande programmée.

7. Procédé selon la revendication 6, caractérisé en ce que la série conforme au modèle désiré ou son négatif est conçue avec l'assistance d'un programme sur un écran graphique relié à un ordinateur et est mémorisée sous une forme lisible par machine dans la mémoire de l'ordinateur, en ce que le modèle mémorisé est soumis, sous la commande d'un programme, à une réduction dimensionnelle, à une décomposition en modèles partiels réduits et ensuite à un agrandissement des modèles partiels réduits jusqu'à la grandeur désirée, les modèles partiels mémorisés et alors existants sont convertis dans un post-processeur en ordres servant à la commande d'un faisceau électronique, auquel cas les deux modèles partiels sont respectivement transmis de façon latente dans une couche sensible au rayonnement et déposés sur le substrat de masque ou bien sur une couche métallique recouvrant le substrat de masque, les couches sensibles au rayonnement sont dveloppées, les modèles partiels contenus dans les couches sensibles au rayonnement sont transmis soit au moyen d'un processus classique d'addition ou de soustraction dans le substrat de masque ou bien dans la couche métallique placée sur le substrat de masque, les modèles partiels sont ensuite transférés dans deux étapes successives d'irradiation, en utilisant les masques, avec un alignement précis l'un par rapport à l'autre, dans une couche sensible au rayonnement recouvrant un substrat et la couche est ensuite développée.

8. Procédé selon une des revendications 4 à 7, caractérisé en ce que les deux masques sont agencés sous la forme d'un masque perforé, dans lequel les deux modèles partiels sont disposés dans des positions mutuellement adjacentes et dans lequel les éléments des modèles partiels sont des trous traversants.

9. Procédé selon la revendication 7, caractérisé en ce que, lors d'une conception de modèle, les éléments de modèles partiels ménagés ultérieurement sous forme de trous (24) dans le masque sont réalisés suffisamment gros pour dépasser la valeur désirée de la tolérance de fabrication se manifestant au maximum lors de la réalisation des trous et en ce que, après la réalisation des trous, l'écart réel entre leurs dimensions et une valeur de consigne est déterminé et en ce qu'enfin la grosseur désirée des trous est produite par dépôt de matière (23) sur les parois (22) des trous.

10. Procédé selon la revendication 9, caractérisé en ce que la matière (23) est déposée par vaporisation en oblique sur la surface de masque tournant autour d'un axe perpendiculaire à la surface de masque ou bien par pulvérisation cathodique.

11. Procédé selon la revendication 9 ou 10, caractérisé en ce que, comme matière (23), on dépose un métal bon conducteur, comme par exemple de l'or.

FIG.1

FIG.2

FIG.3

FIG.4

FIG.5

FIG.7

FIG.8

FIG.6A

FIG.6B

FIG.6C

FIG.6D